# EUROPEAN PATENT SPECIFICATION

(11) **EP 1 025 625 B1**
(45) Date of publication and mention of the grant of the patent: **22.12.2004**
(21) Application number: 97949337.6
(22) Date of filing: 23.10.1997
(51) Int. Cl.: H01S 5/10

(54) **FILAMENTED MULTI-WAVELENGTH VERTICAL-CAVITY SURFACE EMITTING LASER AND FABRICATION METHOD**
FILAMENTIERTER OBERFLACHENEMITTIERENDER MULTIWELLENLÄNGENLASER MIT VERTIKALEM RESONATOR UND HERSTELLUNGSVERFAHREN
LASER A CAVITE VERTICALE ET A EMISSION PAR LA SURFACE DU TYPE A FILAMENTS ET A LONGUEURS D'ONDES MULTIPLES ET METHODE DE FABRICATION

(43) Date of publication of application: 09.08.2000
(73) Proprietor: HONEYWELL INC., Minneapolis Minnesota 55408 (US)
(72) Inventor: MORGAN, Robert, A., Plymouth, MN 55447 (US)
(74) Representative: Fox-Male, Nicholas Vincent Humbert
(86) International application number: PCT/US1997/018952
(87) International publication number: WO 1999/021252

(56) References cited:
- EP-A- 0 744 799
- US-A- 5 359 447
- ORENSTEIN M ET AL: "TWO-DIMENSIONAL PHASE-LOCKED ARRAYS OF VERTICAL-CAVITY SEMICONDUCTOR LASERS BY MIRROR REFLECTIVITY MODULATION" APPLIED PHYSICS LETTERS, vol. 58, no. 8, 25 February 1991, pages 804-806, XP000233503
- CUNNINGHAM D G ET AL: "MODAL NOISE PENALTIES FOR DATA COMMUNICATION LINKS EMPLOYING LARGE AREA VCSELS" ELECTRONICS LETTERS, vol. 31, no. 25, 7 December 1995, pages 2147-2149, XP000546782

## Description

### BACKGROUND OF THE INVENTION

This invention relates to the field of semiconductor lasers, and particularly relates to vertical cavity surface emitting lasers. More particularly, this invention relates to vertical cavity surface emitting lasers that provide a filamented multi-wavelength light output.

Conventional semiconductor lasers have found widespread use in modem technology as the light source of choice for various devices, e.g., communication systems, compact disc players, and so on. The typical semiconductor laser is a double heterostructure with a narrow bandgap, high refractive index layer surrounded on opposed major surfaces by wide bandgap, low refractive index layers. The low bandgap layer is termed the "active layer", and the bandgap and refractive index differences serve to confine both charge carriers and optical energy to the active layer or region. Opposite ends of the active layer have mirror facets which form the laser cavity. The cladding layers have opposite conductivity types and when current is passed through the structure, electrons and holes combine in the active layer to generate light.

Several types of surface emitting lasers have been developed. One such laser of special promise is termed a "vertical cavity surface emitting laser" (VCSEL). (See, for example, "Surface-emitting microlasers for photonic switching and interchip connections", Optical Engineering, 29, pp. 210-214, March 1990, for a description of this laser. For other examples, note U.S. Patent No. 5,115,442, by Yong H. Lee et al., issued May 19, 1992, and entitled "Top-emitting Surface Emitting Laser Structures", which is hereby incorporated by reference, and U.S. Patent No. 5,475,701, issued on December 12, 1995 to Mary K. Hibbs-Brenner, and entitled "Integrated Laser Power Monitor", which is hereby incorporated by reference. Also, see "Top-surface-emitting GaAs four-quantum-well lasers emitting at 0.85µm", Electronics Letters, 26, pp. 710-711, May 24, 1990.) The laser described has an active region with bulk or one or more quantum well layers. On opposite sides of the active region are mirror stacks which are formed by interleaved semiconductor layers having properties, such that each layer is typically a quarter wavelength thick at the wavelength (in the medium) of interest thereby forming the mirrors for the laser cavity. There are opposite conductivity type regions on opposite sides of the active region, and the laser is typically turned on and off by varying the current through the active region.

For several reasons, it is desirable to use surface emitting devices. For example, surface emitting devices can be fabricated in arrays with relative ease while edge emitting devices cannot be as easily fabricated. An array of lasers can be fabricated by growing the desired layers on a substrate and then patterning the layers to form the array. Individual lasers may be separately connected with appropriate contacts. Such arrays are potentially useful in such diverse applications as, for example, image processing, inter-chip communications (i.e., optical interconnects), and so forth. Second, typical edge-emitter lasers are turned on and off by varying the current flow through the device. This typically requires a relatively large change in the current through the device which is undesirable; the surface emitting laser, described below, requires lower drive current, and thus the change of current to switch the VCSEL need not be large.

High-yield, high performance VCSELs have been demonstrated, and exploited in commercialization. Top-surface-emitting AlGaAs-based VCSELs are producible in a manner analogous to semiconductor integrated circuits, and are amenable to low-cost high-volume manufacture and integration with existing electronics technology platforms. Moreover, VCSEL uniformity and reproducibility have been demonstrated using a standard, unmodified commercially available metal organic vapor phase epitaxy (MOVPE) chamber and molecular beam epitaxy (MBE) giving very high device yields.

VCSELs are expected to provide a performance and cost advantages in fast (e.g. Gbits/s) medium distance (e.g. up to approximately 1000 meters) single or multichannel data link applications, and numerous optical and/or imaging applications. This results from their inherent geometry, which provides potential low-cost high performance transmitters with flexible and desirable characteristics.

In some applications, it may be desirable to use multi-mode VCSELs to overcome data communication errors associated with mode-selective losses in multi-mode optical fiber. This may arise, for example, in an optical link requiring numerous mode-selective connectors or with inadequate control in emitter or receiver coupling. In addition, in imaging or spatial applications such as CD laser applications, multi-mode VCSELs may exhibit less speckle than single mode lasers, likewise reducing the bit error rate.

One suggested approach to alleviate mode-selective losses and/or speckle penalties is to provide broad-area VCSELs. A broad-area VCSEL has a relatively large transverse dimensions relative to the light produced by the VCSEL. A limitation of broad area VCSELs is that a relatively large lateral dimension may be required to produce a multi-mode light output, particularly at a low bias current. It is known that as the size of the lasing cavity decreases, the bias current required to produce a multi-mode light output increases. Thus, to produce a multi-mode light output at a relatively low bias current, a relatively large lateral dimension (broad area) may be required. This increases the needed drive power and may limit the fabrication density of VCSEL elements and/or arrays.

Another limitation of any type of VCSEL that produce a strictly multi-mode light output (e.g. broad area VCSELs) is that some modes may be attenuated more than other modes by the optical link. Also, it may be difficult to predict which of the modes will be attenuated more than the others, particularly since each optical link application may be different. Thus, to help ensure that the projected range of optical links applications remain reliable, it may be necessary to drive relatively large bias currents through the VCSEL to help ensure that a large number of modes are produced thereby.

### SUMMARY OF THE INVENTION

The present invention provides a method as defined in Claim 1 hereinafter.

The method may include the features of any one or more of dependent Claims 2 to 26.

The present invention also provides a VCSEL produced by the method of any of Claims 1 to 24.

The present invention also provides a VCSEL as defined in Claim 25.

The VCSEL may include the features of Claim 26.

The present invention overcomes many of the disadvantages of the prior art by providing a VCSEL that provides a filamented light output, rather than a strictly multi-mode light output. A filamented light output differs from a multi-mode light output in that each filament operates like a separate laser, substantially independent from the other filaments. Each filament is typically coherent and may operate in a single mode, and is substantially incoherent with the other filaments. Like a multi-mode light output, a filamented light output may not be as susceptible to bit error rates resulting from mode selective losses as a single-mode emission might be when coupled into a multi-mode fiber. However, unlike a broad-area VCSEL, the VCSEL of the present invention may have a low drive current, exhibit high performance, and occupy less physical area than a broad-area (wide aperture) VCSEL.

The present invention contemplates laterally altering the injection current and/or reflectance of the VCSEL at a number of discrete locations. To accomplish this, a number of discrete objects may be positioned adjacent to or within one or both of the cladding mirrors, or within the active region itself. The discrete objects are non-uniformly spaced, and non-uniformly sized. The discrete objects alter the reflectance and/or current injection (and thus the gain) of the VCSEL at corresponding discrete locations, thereby causing the filamented light output. It is contemplated that each of the number of discrete objects may be any object, including patterned metal or dielectric objects, vias, or groups or clusters of dopant atoms or material.

### BRIEF DESCRIPTION OF THE DRAWINGS

Other objects of the present invention and many of the attendant advantages of the present invention will be readily appreciated as the same becomes better understood by reference to the following detailed description when considered in connection with the accompanying drawings, in which like reference numerals designate like parts throughout the figures thereof and wherein:
Figure 1 is a schematic illustration of a planer, current-guided, GaAs/AlGaAs top surface emitting vertical cavity laser with a number of patterned objects on the top surface of the top mirror region in accordance with the present invention;
Figure 2 is a schematic illustration of a top portion of a VCSEL in accordance with the present invention, with a number of patterned objects disposed on a selected layer of the top mirror region;
Figure 3 is a schematic illustration of a top portion of a VCSEL in accordance with the present invention, with a number of patterned vias disposed within a selected layer of the top mirror region;
Figure 4 is a schematic illustration of a top portion of a VCSEL in accordance with the present invention, wherein a selected layer of the top mirror region is heavily doped, beyond the saturation limit, to provide a number of randomly distributed participates therein;
Figure 5A and Figure 5B are graphs of the optical spectrum for a VCSEL constructed in accordance with Figure 4 at a variety of drive currents showing that even at low drive currents, a number of independent wavelengths are produced thereby;
Figure 6 is a representation of a near field observed for a VCSEL constructed in accordance with Figure 4, showing that the near field includes randomly distributed filament modes, each incoherent with the others;
Figure 7 is a graph of the divergence pattern for a VCSEL constructed in accordance with Figure 4, showing that the emission pattern is nearly symmetrical and circular, and having Full Width Half Max (FWHM) of about 24 degrees;
Figure 8 is an common L-I-V graph for a VCSEL constructed in accordance with Figure 4;
Figure 9 is a graph of the small signal analog modulation response for a VCSEL constructed in accordance with Figure 4, showing that even when the drive current is just above threshold, the 3dB electrical bandwidth is greater than 3 GHz;
Figure 10 shows a number of eye diagrams for a VCSEL constructed in accordance with Figure 4 taken at the fiber-channel standard bit-rate of 1.062 Gbit/s as a function of bias showing a large degree of non-uniformity in the bias current can be tolerated without serious performance consequences; and
Figure 11 is a graph of the measured Bit Error Ratio (BER) vs. power for a VCSEL constructed in accordance with Figure 4, showing that even when biased up to only 1mA below the threshold, no penalty is observed.

### DETAILED DESCRIPTION OF THE PREFERRED EMBODIMENTS

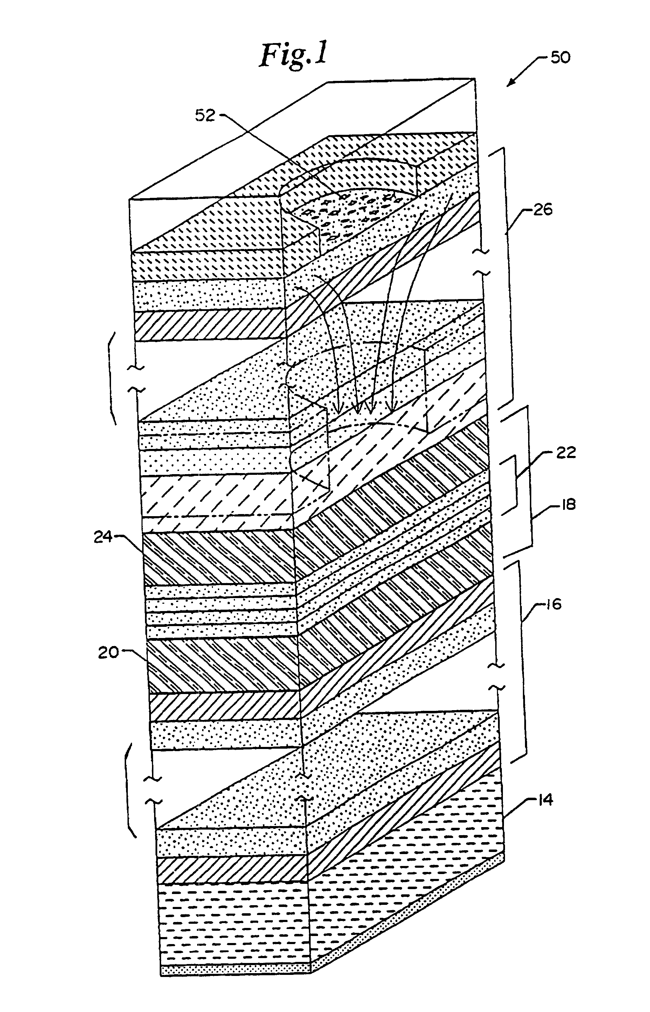

Figure 1 is a schematic illustration of a planer, current-guided, GaAs/AlGaAs top surface emitting vertical cavity laser 50 with a number of patterned objects 52 disposed on the top mirror region 26. In a preferred embodiment, the n-doped substrate 14 is grown by metal organic vapor phase epitaxy (MOVPE) on a 3 inch diameter n-doped GaAs substrate. The n-type mirror stack 16 is preferably a 30.5 period n-doped (Te, 1x10¹⁸cm⁻³, nominal) Al_{0.16}Ga_{0.84}As/AlAs bottom quarter wave stack, wherein each period contains a 2x10⁻⁸ metres (200-Å) thick graded region. Spacer 18 has a bottom confinement layer 20 and a top confinement layer 24, wherein each of the confinement layers is formed from Al_{0.6} Ga_{0.4} As. The thickness of each confinement layer 20 and 24 is chosen to make the resulting spacer 18 preferably one wavelength thick. The active region 22 is preferably a three 7x10⁻⁹ metre (70-Å) thick GaAs quantum-well. The p-type mirror stack 26 is preferably a 22 period p-doped (Zn, 1x10¹⁸ cm⁻³, nominal) Al_{0.6} Ga_{0.84} As/AlAs DBR, wherein each period contains a 2x10⁻⁸ metre (200-Å) thick graded region. Numerous device sizes, types and arrays may be simultaneously batch-fabricated, exploiting the flexibility of this technology platform.

To achieve filamentation, the present invention contemplates providing a number of discrete objects 52 anywhere in the lasing cavity or in the exit aperture. That is, the discrete objects 52 may be positioned anywhere within or on the p-type mirror stack 26, the spacer 18 or the n-type mirror stack 16. In the exemplary embodiment, the discrete objects 52 may be provided on top of the p-type mirror stack 26, as shown. The discrete objects 52 may be fabricated by using any number of materials, for example a patterned metal or dielectric material.

To fabricate the discrete objects 52, a layer of metal or dielectric may be deposited on the top surface of the p-type mirror stack 26. Using a mask, portions of the metal or dielectric layer may be selectively removed using a known etching technique to leave only the discrete objects 52. Preferably, the discrete objects 52 are randomly spaced, and are of different sizes. In this configuration, the discrete objects 52 may alter the reflectance and/or resistance of the p-type mirror stack 26 at discrete locations. The altered reflectance may provide diverse-Finesse lateral subcavities in the lasing aperture. The altered resistance may provide a number of discrete locations where the injection current is increased into the active region, and thus increasing the gain at those locations. In either case, a filamented light output may be provided.

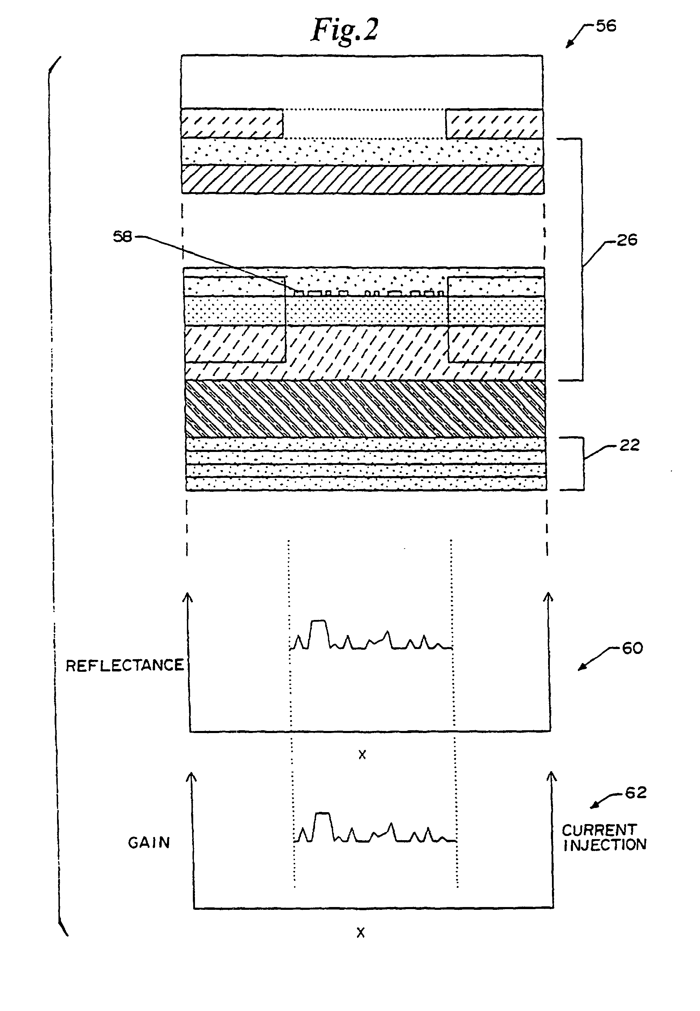

Figure 2 is a schematic illustration of a top portion of a VCSEL 56 in accordance with the present invention. The illustrative embodiment shown in Figure 2 is similar to the embodiment shown in Figure 1, except that the discrete objects 58 are disposed on a selected layer within the p-type mirror stack 26, rather than on the top layer.

The graph shown at 60 illustrates one theoretical basis for why the discrete objects may cause the VCSEL 56 to produce a filamented light output. The graph 60 shows that the reflectance of the p-type mirror 26 may be altered at a number of discrete locations, which correspond to the discrete objects disposed within the p-type mirror stack 26. The discrete objects 58 may produce a number of diverse-finesse lateral subcavities within the lasing aperture, and thus may result in a filamented light output.

The graph shown at 62 illustrates another theoretical basis for why the discrete objects 58 may cause the VCSEL 56 to produce a filamented light output. The graph 62 shows that the injection current provided to the active region 22, by the p-type mirror 26, may be altered at a number of discrete locations. The number of discrete locations may correspond to the locations of the discrete objects 58 disposed within the p-type mirror stack 26. Because of the altered injection current, the gain of the active region 22 may also be altered at the discrete locations. These discrete gain variations are, at least in part, responsible for the filamented light output. It is recognized that the filamented output may also result from a combination of both of the above-described effects.

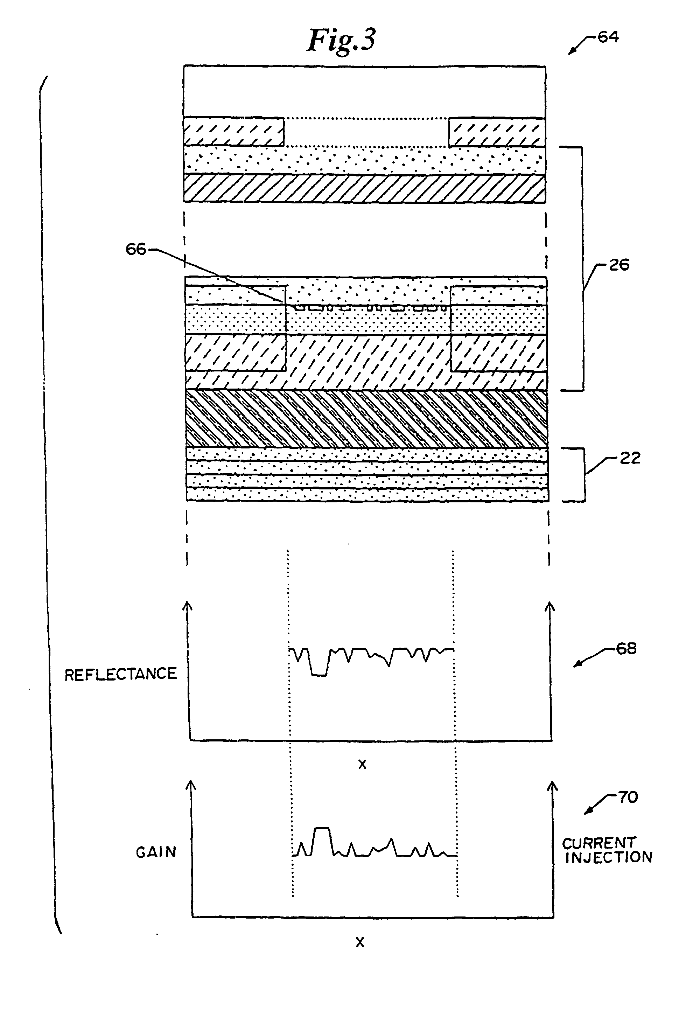

Figure 3 is a schematic illustration of a top portion of a VCSEL 64 in accordance with the present invention with a number of patterned vias 66 disposed within a selected layer of the p-type mirror stack 26. The illustrative embodiment shown in Figure 3 is similar to the embodiment shown in Figure 1. except that vias 66 are disposed on a selected layer within the p-type mirror stack 26.

The graph shown at 68 illustrates one theoretical basis for why the vias 66 may cause the VCSEL 64 to produce a filamented light output. The graph 68 shows that the reflectance of the p-type mirror 26 may be altered at a number of discrete locations, which correspond to the vias 66 disposed within the p-type mirror stack 26. In this embodiment, the vias 66 may produce a number of diverse-finesse lateral sub-cavities within the lasing aperture, and thus may result in a filamented light output.

The graph shown at 70 illustrates another theoretical basis for why the vias 66 may cause the VCSEL 56 to produce a filamented light output. The graph 70 shows that the injection current provided to the active region 22, by the p-type mirror 26, may be altered at a number of discrete locations. The number of discrete locations may correspond to the locations of the vias disposed within the p-type mirror stack 26. Because of the altered injection current, the gain of the active region 22 may also be altered at the discrete locations. These discrete gain alterations are, at least in part, responsible for filamented light output. It is recognized that the filamented output may also result from a combination of both of the above-described effects.

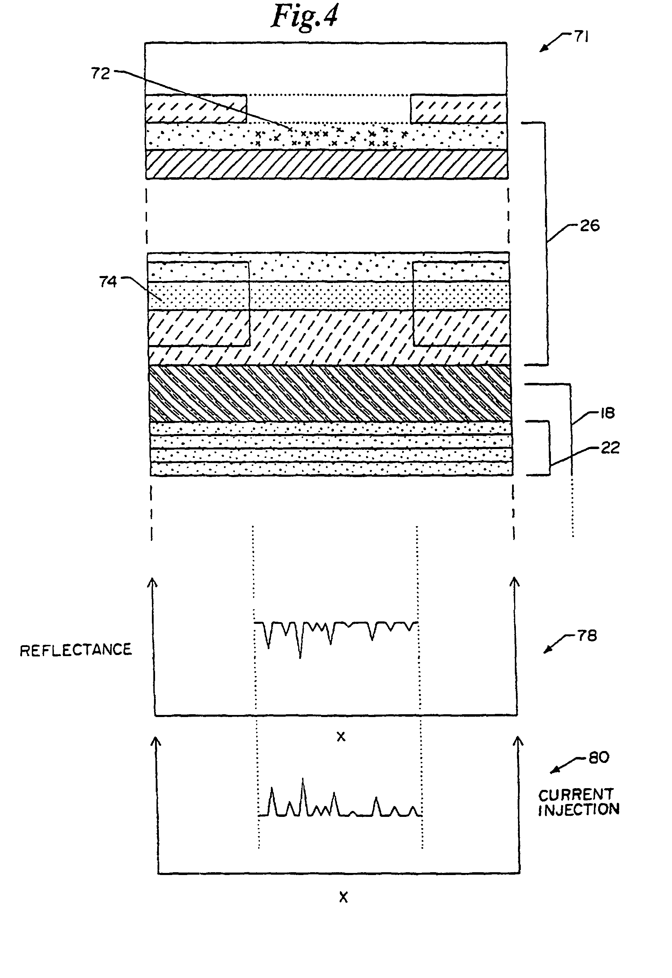

Figure 4 is a schematic illustration of a top portion of a VCSEL 70 in accordance with the present invention, wherein a selected layer of the top mirror region is heavily doped, beyond the saturation limit, to provide a number of randomly distributed clusters or participates 72 therein. In a preferred embodiment a top approximately 3x10⁻⁷metre (3000Å) of a selected layer within the p-type mirror stack 26 is doped with Zn beyond the saturation limit (between 1x10¹⁸cm⁻³ and 1x10¹⁹cm⁻³ of Zn in AlGaAs). Because the p-type mirror stack 26 is normally a crystalline structure, doping the p-type mirror stack 26 at a concentration above the saturation limit may cause the Zn dopant atoms to be non-uniformly distributed throughout the material. Rather, it is believed that some of thedopant atoms may be distributed in groups or clusters. It is these groups or clusters that are termed participates within the p-type mirror stack 26. It is believed that these participates alter the reflectance and/or resistance (and thus effective current injection) of the p-type mirror stack 26 at discrete locations, thus contributing to the filamented light output.

The graph shown at 78 illustrates one theoretical basis for why the dopants cause the VCSEL 71 to produce a filamented light output. The graph 78 shows that the reflectance of the p-type mirror 26 may be altered at a number of discrete locations, which correspond to the participates 72 in the p-type mirror stack 26. In this embodiment, the participates may produce a number of diverse-finesse lateral sub- cavities within the lasing aperture, and thus result in a filamented light output.

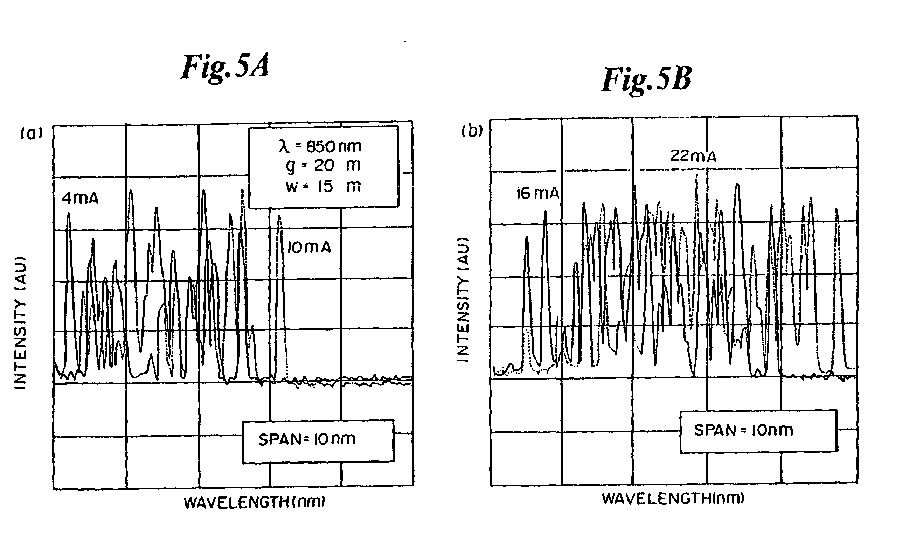

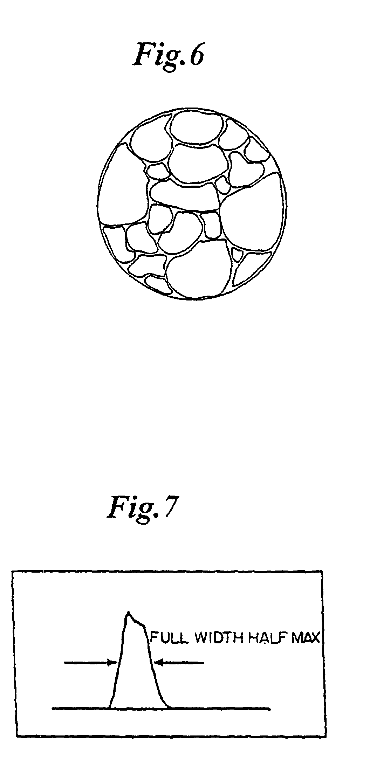

The graph shown at 80 illustrates another theoretical basis for why the dopants cause the VCSEL 71 to produce a filamented light output. The graph 80 shows that the injection current provided to the active region 22, by the p-type mirror 26, may be altered at a number of discrete locations. The number of discrete locations may correspond to the locations of the participates 72 disposed within the p-type mirror stack 26. Because of the altered injection current, the gain of the active region 22 may also be altered at the discrete locations. These discrete gain variations are, at least in part, responsible for the filamented light output. It is recognized that the filamented output may result from a combination of both of the above-described effects. In either case, a filamented output was observed for a VCSEL constructed in accordance with Figure 4 (see Figures 5A, 5B and 6 below).

While Figure 4 only shows participates in a single layer within the p-type mirror stack 26, it is contemplated that any number of layers of the p-type mirror stack 26, the n-type mirror stack 16 or the spacer 18 may be doped to provide the participates therein.

Figure 5A and Figure 5B are graphs of the optical spectrum for a VCSEL constructed in accordance with Figure 4. Figure 5A shows the optical spectrum for a VCSEL having the top about 3x10⁻⁷ metre(3000Å) of the p-type mirror stack 26 heavily doped (greater than 10¹⁸cm⁻³) with Zn. The optical spectrum for a bias current of 4 mA is shown in the dark line, and the optical spectrum for a bias current of 10 mA is shown in the dashed line. Figure 5B shows the optical spectrum for a bias current of 16 mA in the dark line, and shows the optical spectrum for a bias current of 22 mA in the dashed line.

It is noted that even with a bias current of only 4 mA, the VCSEL of the present invention produces about 15 independent wavelengths. At a 10 mA bias current, the VCSEL produces about 20 independent wavelengths. In addition, the optical spectrum is wide enough about 5x10⁻⁹ metre (5 nm) for incoherence but narrow enough not to be overly limited by fiber chromatic dispersion.

Figure 6 is a representation of a near field observed for a VCSEL constructed in accordance with Figure 4. The near field includes a number of randomly distributed filament modes, each mutually incoherent with one another. Further, each filament has a slightly different modal size, and experiences a different temperature, depending on the filaments location within the lasing cavity. Thus, each filament produces a slightly different wavelength.

Figure 7 shows the resulting divergence pattern for the near field shown in Figure 6. The divergence pattern is the incoherent superposition of the number of filaments (and some multi-modes), resulting in a nearly circularly symmetric emission pattern of about 24 degrees Full Width Half Maximum (FWHM). This corresponds to an average (l/e²) filament diameter of approximately 1.8 microns. As indicated above, this wide spectrum (see Figures 5A and 5B) coupled with these laser-like characteristics offer the possibility of reducing bit error rates resulting from mode selective loss in multi-mode optical fiber data links. Likewise, speckle effects in imaging and other spatial applications such as CDS may be reduced because of speckle averaging. Thus, the VCSEL of the present invention has a number of advantages provided by a conventional laser including speed, efficiency and power, but does not suffer from many of the disadvantages associated with high coherence.

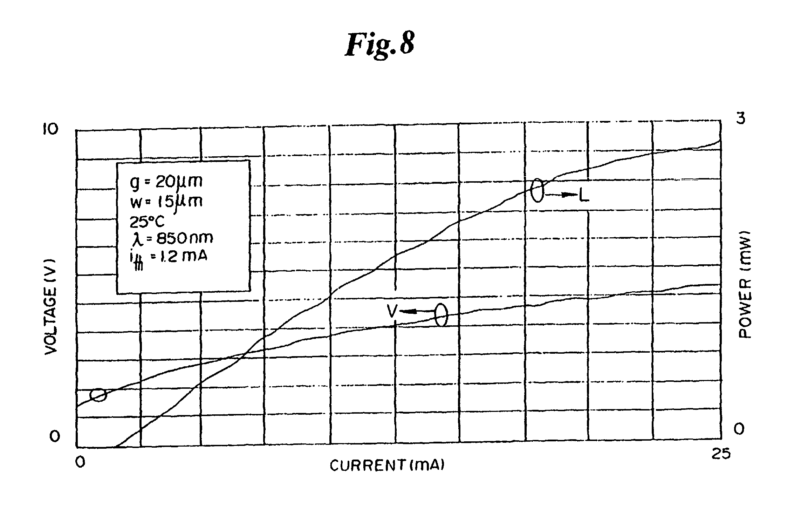

Figure 8 is a common L-I-V graph for a VCSEL constructed in accordance with Figure 4. It has been found that threshold currents and voltages were commonly below 2 mA and 1.8V, respectively, over an 830 to 860 nm wavelength regime. The temperature performance of these VCSELs was found to be similar to more conventional VCSELs, and the threshold current typically varied by less than ±0.5 mA, at 860 nm, over a 130°C temperature range of -10°C to 120°C. This illustrates the robustness and practicality of the present invention.

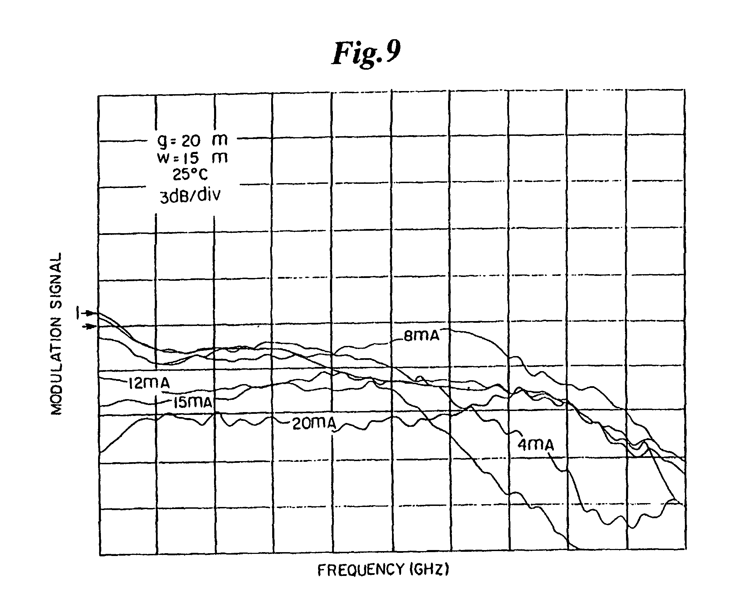

Figure 9 is a graph of the small signal analog modulation response for a VCSEL constructed in accordance with Figure 4. For this measurement, the VCSEL was packaged on a microwave header including a "K" connector terminated into a 50Ω Alumina line. A Hewlett Packard™ 8510 network analyzer was used to make the small signal measurements together with a New Focus™ 25 GHz photo diode detector. Figure 9 shows that even when the drive current is just above threshold (e.g. 4 mA), the 3dB bandwidth is greater than 3 GHz. At a typical drive current of 8 mA, the 3dB bandwidth is about 8.3 GHz. With a 20 mA drive current, the 3dB bandwidth is about 9.5 GHz. Importantly, for low drive currents (e.g. less than 10 mA) multi-GHz bandwidths are obtained. This is far greater than standard LED devices or even typical CD laser sources.

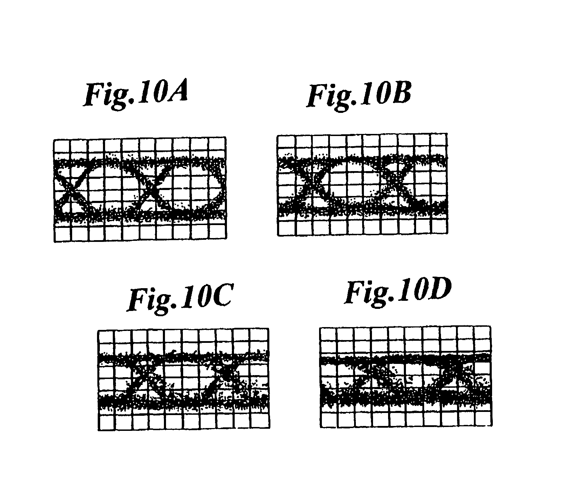

Figure 10 shows a number of eye diagrams for a VCSEL constructed in accordance with Figure 4 taken at the fiber-channel standard bit-rate of 1.062 Gbit/s as a function of bias. To obtain the eye diagrams, the VCSEL was butt-coupled through a 100 meter 62.5µm/125µm standard graded index multi-mode fiber. The filamented output was detected using a Hewlett Packard™ 83412B detector and displayed on a digitizing oscilloscope with a limiting bandwidth of about 1 GHz, acting as a system filter. The VCSEL used for this measurement had a threshold current of Ith = 1.75 mA, and a modulation current of Imod = 6 mA. Figure 10 shows a number of bias conditions including Ibias = Ith, Ibias = Ith - 0.5 mA, Ibias = Ith - 1.0 mA, and Ibias = Ith - 1.5 mA. Note that for the last case, Ibias = 1.75 mA - 1.5 mA = 0.25 mA. Thus, even for a below threshold bias current of only 0.25 mA, a wide-open eye is obtained, unlike similar broad-area multi-transverse mode VCSELs which require above threshold biasing and larger modulation currents.

The above results demonstrate that a large degree of non-uniformity in the threshold current can be tolerated at high speed without serious consequences. This intrinsic robust performance indicates that the VCSEL of the present invention can withstand manufacturing tolerances across a wafer and can be utilized in a VCSEL array (wherein the threshold current may vary) to further reduce the cost and increase the performance of a system.

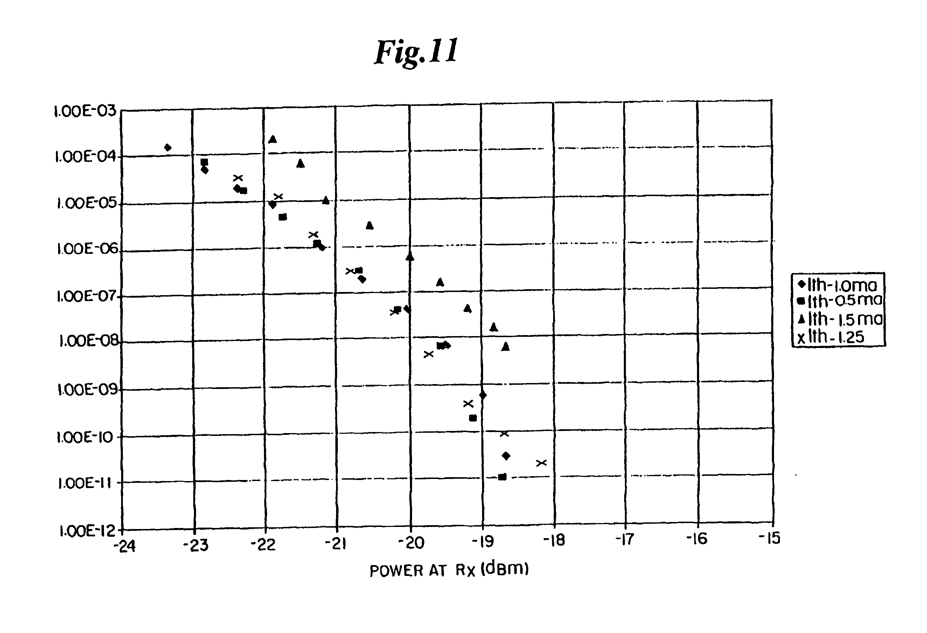

Figure 11 is a graph of the measured Bit Error Ratio (BER) vs. power for a VCSEL constructed in accordance with Figure 4. The graph shows the BER for four bias conditions including Ibias = Ith - 0.5 mA, Ibias = Ith - 1.0 mA, and Ibias = Ith - 1.25 mA, and Ibias = Ith - 1.5 mA. Note that for the last case, the Ibias = 1.75 mA - 1.5 mA = 0.25 mA. No errors were detected in all four bias conditions over a 30 minute test, at a received power of -18 dBm. Even when biased up to 1 mA below threshold, no penalty is observed. Moreover, less than a 1 dB penalty is incurred for the low (0.25 mA) bias condition. where the power was limited to about -18 dBm due to losses in the system for this low (6 mA) modulation current.

Having thus described the preferred embodiments of the present invention, those of skill in the art will readily appreciate that the teachings found herein may be applied to yet other embodiments within the scope of the claims hereto attached.

## Claims

1. A method of manufacturing a vertical-cavity surface emitting laser VCSEL comprising a first mirror region (26) electrically coupled to a first terminal, the first mirror region (26) generally having a first reflectance value, a second mirror region (16) situated substantially parallel to the first mirror (26) and electrically coupled to a second terminal, the second mirror region (16) generally having a second reflectance value and an active region (22) situated between the first and second mirror regions (16, 26), the method comprising laterally altering the injection current and/or reflectance of the VCSEL at a number of non-uniformly sized and non-uniformly positioned discrete locations such as to produce a filamented light output.

2. A method according to Claim 1 wherein at least one of the first and second mirror regions (16, 26) has a number of discrete locations (52, 58, 66, 72), wherein each of the number of discrete locations (52, 58, 66, 72) have a different reflectance value than the corresponding first and second reflectance value.

3. A method according to Claim 1 or 2 wherein the first and second mirror regions (16, 26) each comprise of number a layers, wherein each of the number of discrete locations (58, 66, 72) corresponding to an object positioned within one or more of the number of layers.

4. A method according to Claim 3 wherein the first and second mirror regions (16, 26) are formed from one or more materials, the objects (52, 58, 66, 72) being formed from a material that is different from the one or more materials.

5. A method according to Claim 3 wherein the object (52, 58, 66, 72) comprises one or more dopant atoms.

6. A method according to Claim 4 wherein the first and second mirror regions (16, 26) each comprise a number of layers, wherein selected ones of the number of layers are saturated with a predetermined dopant, thereby forming the number of discrete locations (52, 58, 66, 72).

7. A method according to Claim 1 wherein the first and second mirror regions (16, 26) each comprise a number of layers, wherein at least one of the number of layers includes a patterned layer (52) wherein the pattern corresponds to the number of discrete locations (52, 58, 66, 72).

8. A method according to Claim 7 wherein the patterned layer (52) comprises a patterned metal layer.

9. A method according to Claim 7 wherein the patterned layer (52) comprises a patterned dielectric layer.

10. A method according to Claim 1 wherein the first and second mirror regions (16, 26) each comprise a number of layers, wherein each of the number of discrete locations (52, 58, 66, 72) corresponding to a via positioned within one or more of the number of layers.

11. A method according to Claim 1 wherein a first portion of the number of discrete locations (52, 58, 66, 72) are of a first size and a second portion of the number of discrete locations (52, 58, 66, 72) are of a second size.

12. A method according to Claim 1
wherein at least one of the first and second mirror regions (16, 26) has a number of discrete locations (52, 58, 66, 72), wherein each of the number of discrete locations (52, 58, 66, 72) have a different resistance value than the corresponding first and second resistance value

13. A method according to Claim 12 wherein the first and second mirror regions (16, 26) each comprise a number of layers, wherein each of the number of discrete locations (52, 58, 66, 72) corresponding to an object positioned within one or more of the number of layers.

14. A method according to Claim 13 wherein the first and second mirror regions (16, 26) are formed from one or more materials, the object (52, 58, 66, 72) being formed from a material that is different from the one or more materials.

15. A method according to Claim 13 wherein the object (52, 58, 66, 72) comprises one or more dopant atoms.

16. A method according to Claim 13 wherein the first and second mirror regions (16, 26) each comprise a number of layers, wherein selected ones of the number of layers are saturated with a predetermined dopant, thereby forming the number of discrete locations (52, 58, 66, 72).

17. A method according to Claim 12 wherein the first and second mirror regions (16, 26) each comprise a number of layers, wherein at least one of the number of layers includes a patterned layer (52) wherein the pattern corresponds to the number of discrete locations (52, 58, 66, 72).

18. A method according to Claim 17 wherein the patterned layer (52) comprises a patterned metal layer.

19. A method according to Claim 17 wherein the patterned layer (52) comprises a patterned dielectric layer.

20. A method according to Claim 12 wherein the first and second mirror regions (16, 26) each comprise a number of layers, wherein each of the number of discrete locations (52, 58, 66, 72) corresponding to a via positioned within one or more of the number of layers.

21. A method according to Claim 12 wherein a first portion of the number of discrete locations (52, 58, 66, 72) are of a first size and a second portion of the number of discrete locations (52, 58, 66, 72) are of a second size.

22. A method according to Claim 1, comprising:
providing an exit window positioned above the first mirror region (26); and
providing a patterned layer (52) situated above the first mirror region (26) and substantially aligned with the exit window, wherein the patterned layer (52) comprises a number of discrete locations (52, 58, 66, 72) of a predetermined material.

23. A method according to Claims 22 wherein the patterned layer (52) comprises a number of vias.

24. A method according to Claim 1 comprising:
providing an active region (22) situated between the first and second mirror regions (16, 26), the active region (22) generally having a first gain, but further having a number of discrete locations wherein the gain at each of discrete locations is different from the first gain value, thereby providing the filamented light output.

25. A vertical-cavity surface emitting laser VCSEL for providing a filamented light output, comprising:
a first mirror region (26) electrically coupled to a first terminal, the first mirror region (26) generally having a first reflectance value;
a second mirror region (16) situated substantially parallel to the first mirror (26) and electrically coupled to a second terminal, the second mirror region (16) generally having a second reflectance value;
at least one of the first and second mirror regions (16, 26) having a plurality of non-uniformly sized and non-uniformly positioned discrete locations (52, 58, 66, 72), wherein each of the number of discrete locations (52, 58, 66, 72) have a different reflectance value than the corresponding first and second reflectance value such as to provide a filamented light output; and
an active region (22) situated between the first and second mirror regions (16, 26).

26. A VCSEL according to Claim 25 wherein the first and second mirror regions (16, 26) each comprise a number of layers, wherein each of the number of discrete locations (58, 66, 72) correspond to an object positioned within one or more of the number of layers, an object being one or more of the following:
• A material different from those of the first and second mirror regions ;
• One or more dopant atoms or groups or clusters thereof;
• A patterned layer (e.g. of metal or dielectric);
• Vias;
• A resistance and/or gain different from those of the first and second mirror regions.

27. A VCSEL according to claim 25 or 26 obtainable by the method of any of claims 1 to 24.

## Patentansprüche

1. Verfahren zum Herstellen eines oberflächenemittierenden Lasers mit vertikalem Resonator (VCSEL), umfassend einen ersten Spiegelbereich (26), der elektrisch mit einem ersten Anschluss gekoppelt ist, wobei der erste Spiegelbereich (26) im Allgemeinen einen ersten Reflexionswert hat, einen zweiten Spiegelbereich (16), der im Wesentlichen parallel zum ersten Spiegel (26) angeordnet ist und elektrisch mit einem zweiten Anschluss gekoppelt ist, wobei der zweite Spiegelbereich (16) im Allgemeinen einen zweiten Reflexionswert hat und sich ein aktiver Bereich (22) zwischen dem ersten und zweiten Spiegelbereich (16, 26) befindet, wobei das Verfahren das laterale Ändern des Injektionsstroms und/oder der Reflexion des VCSEL an einer Anzahl nicht einheitlich großer und nicht einheitlich positionierter diskreter Orte umfasst, um so einen filamentierten Lichtausgang zu schaffen.

2. Verfahren nach Anspruch 1, wobei mindestens einer der ersten und zweiten Spiegelbereiche (16, 26) eine Anzahl diskreter Orte (52, 58, 66, 72) aufweist, wobei jeder der Anzahl diskreter Orte (52, 58, 66, 72) einen anderen Reflexionswert als den entsprechenden ersten und zweiten Reflexionswert hat.

3. Verfahren nach Anspruch 1 oder 2, wobei der erste und zweite Spiegelbereich (16, 26) jeweils eine Anzahl Schichten aufweist, wobei jeder der Anzahl diskreter Orte (58, 66, 72) einem Gegenstand entspricht, welcher sich innerhalb einer oder mehrerer der Anzahl Schichten befindet.

4. Verfahren nach Anspruch 3, wobei die ersten und zweiten Spiegelbereiche (16, 26) aus einem oder mehreren Materialien geformt sind, wobei die Gegenstände (52, 58, 66, 72) aus einem Material geformt sind, das sich von dem einen oder mehreren Materialen unterscheidet.

5. Verfahren nach Anspruch 3, wobei der Gegenstand (52, 58, 66, 72) einen oder mehrere Fremdatome aufweist.

6. Verfahren nach Anspruch 4, wobei der erste und zweite Spiegelbereich (16, 26) jeweils eine Anzahl Schichten aufweist, wobei ausgewählte der Anzahl Schichten mit einem vorbestimmten Dortierstoff gesättigt werden, wodurch die Anzahl diskreter Orte (52, 58, 66, 72) gebildet wird.

7. Verfahren nach Anspruch 1, wobei der erste und zweite Spiegelbereich (16, 26) jeweils eine Anzahl Schichten aufweist, wobei zumindest eine der Anzahl Schichten eine gemusterte Schicht (52) aufweist, wobei das Muster der Anzahl diskreter Orte (52, 58, 66, 72) entspricht.

8. Verfahren nach Anspruch 7, wobei die gemusterte Schicht (52) eine gemusterte Metallschicht aufweist.

9. Verfahren nach Anspruch 7, wobei die gemusterte Schicht (52) eine gemusterte dielektrische Schicht aufweist.

10. Verfahren nach Anspruch 1, wobei der erste und zweite Spiegelbereich (16, 26) jeweils eine Anzahl Schichten aufweist, wobei jeder der Anzahl diskreter Orte (52, 58, 66, 72) einem Kontaktloch entspricht, das sich innerhalb einer oder mehrerer der Anzahl Schichten befindet.

11. Verfahren nach Anspruch 1, wobei ein erster Bereich der Anzahl diskreter Orte (52, 58, 66, 72) eine erste Größe und ein zweiter Bereich der Anzahl diskreter Orte (52, 58, 66, 72) eine zweite Größe hat.

12. Verfahren nach Anspruch 1, wobei zumindest einer der ersten und zweiten Spiegelbereiche (16, 26) eine Anzahl diskreter Orte (52, 58, 66, 72) aufweist, wobei jeder der Anzahl diskreter Orte (52, 58, 66, 72) einen anderen Widerstandswert als den entsprechenden ersten und zweiten Widerstandswert hat.

13. Verfahren nach Anspruch 12, wobei der erste und zweite Spiegelbereich (16, 26) jeweils eine Anzahl Schichten aufweist, wobei jeder der Anzahl diskreter Orte (52, 68, 66, 72) einem Gegenstand entspricht, der sich innerhalb einer oder mehrerer der Anzahl Schichten befindet.

14. Verfahren nach Anspruch 13, wobei der erste und zweite Spiegelbereich (16, 26) aus einem oder mehreren Materialien geformt ist, wobei der Gegenstand (52, 58, 66, 72) aus einem Material geformt ist, das sich von dem einen oder mehreren Materialien unterscheidet.

15. Verfahren nach Anspruch 13, wobei der Gegenstand (52, 58, 66, 72) ein oder mehrere Fremdatome aufweist.

16. Verfahren nach Anspruch 13, wobei der erste und zweite Spiegelbereich (16, 26) jeweils eine Anzahl Schichten aufweist, wobei ausgewählte der Anzahl Schichten mit einem vorbestimmten Dotierstoff gesättigt werden, wodurch die Anzahl diskreter Orte (52, 58, 66, 72) gebildet wird.

17. Verfahren nach Anspruch 12, wobei der erste und zweite Spiegelbereich (16, 26) jeweils eine Anzahl Schichten aufweist, wobei zumindest eine der Anzahl Schichten eine gemusterte Schicht (52) aufweist, wobei das Muster der Anzahl diskreter Orte (52, 58, 66, 72) entspricht.

18. Verfahren nach Anspruch 17, wobei die gemusterte Schicht (52) eine gemusterte Metallschicht aufweist.

19. Verfahren nach Anspruch 17, wobei die gemusterte Schicht (52) eine gemusterte dielektrische Schicht aufweist.

20. Verfahren nach Anspruch 12, wobei der erste und zweite Spiegelbereich (16, 20) jeweils eine Anzahl Schichten aufweist, wobei jeder der Anzahl diskreter Orte (52, 58, 66,72) einem Kontaktloch entspricht, das sich innerhalb einer oder mehrerer der Anzahl Schichten befindet.

21. Verfahren nach Anspruch 12, wobei ein erster Bereich der Anzahl diskreter Orte (52, 58, 66, 72) eine erste Größe und ein zweiter Bereich der Anzahl diskreter Orte (52, 58, 66, 72) eine zweite Größe hat.

22. Verfahren nach Anspruch 1, umfassend
das Bereitstellen eines Austrittfensters, das sich oberhalb des ersten Spiegelbereichs (26) befindet, und
Bereitstellen einer gemusterten Schicht (52), die sich oberhalb des ersten Spiegelbereichs (26) befindet und im Wesentlichen mit dem Austrittsfenster ausgerichtet ist, wobei die gemusterte Schicht (52) eine Anzahl diskreter Orte (52, 58, 66, 72) aus einem vorbestimmten Material aufweist.

23. Verfahren nach Anspruch 22, wobei die gemusterte Schicht (52) eine Anzahl Kontaktlöcher aufweist.

24. Verfahren nach Anspruch 1, umfassend
das Bereitstellen eines aktiven Bereichs (22), der sich zwischen dem ersten und zweiten Spiegelbereich (16, 26) befindet, wobei der aktive Bereich (22) im allgemeinen einen ersten Verstärkungswert hat, aber des Weiteren eine Anzahl diskreter Orte aufweist, wobei sich die Verstärkung an jedem der diskreten Orte von dem ersten Verstärkungswert unterscheidet, wodurch der filamentierte Lichtausgang geschaffen wird.

25. Ein oberflächenemittierender Laser mit vertikalem Resonator (VCSEL) zum Schaffen eines filamentierten Lichtausgangs, umfassend
einen ersten Spiegelbereich (26), der elektrisch mit einem ersten Anschluss gekoppelt ist, wobei der erste Spiegelbereich (26) im Allgemeinen einen ersten Reflexionswert hat,
einen zweiten Spiegelbereich (16), der im Wesentlichen parallel zum ersten Spiegel (26) angeordnet ist und elektrisch mit einem zweiten Anschluss gekoppelt ist, wobei der zweite Spiegelbereich (16) im Allgemeinen einen zweiten Reflexionswert hat,
wobei mindestens einer der ersten und zweiten Spiegelbereiche (16, 26) mehrere nicht einheitlich große und nicht einheitlich positionierte diskrete Orte (52, 58, 66, 72) aufweist, wobei jeder der Anzahl diskreter Orte (52, 58, 66, 72) einen anderen Reflexionswert als den entsprechenden ersten und zweiten Reflexionswert hat, um so einen filamentierten Lichtausgang zu schaffen, und
einen aktiven Bereich (22), der sich zwischen dem ersten und zweiten Spiegelbereich (16, 26) befindet.

26. Ein VCSEL nach Anspruch 25, wobei der erste und zweite Spiegelbereich (16, 26) jeweils eine Anzahl Schichten aufweist, wobei jeder der Anzahl diskreter Orte (58, 66, 72) einem Gegenstand entspricht, welcher sich innerhalb einer oder mehrerer der Anzahl Schichten befindet, wobei ein Gegenstand jeweils einer oder mehrere der folgenden Gegenstände ist:
• ein Material, das sich von dem des ersten und zweiten Spiegelbereichs unterscheidet,
• ein oder mehrere Fremdatome oder Gruppen oder Clusters davon,
• eine gemusterte Schicht (z.B. aus Metal oder Dielektrikum),
• Kontaktlöcher,
• ein Widerstand und/oder eine Verstärkung, die sich von denen der ersten und zweiten Spiegelbereiche unterscheiden.

27. Ein VCSEL nach Anspruch 25 oder 26, erhältlich durch das Verfahren nach einem der Ansprüche 1 bis 24.

## Revendications

1. Procédé de fabrication d'un laser à cavité verticale et à émission par la surface VCSEL comprenant une première région de miroir (26) couplée électriquement à une première borne, la première région de miroir (26) ayant généralement une première valeur de réflectance, une deuxième région de miroir (16) située sensiblement parallèlement au premier miroir (26) et couplée électriquement à une deuxième borne, la seconde région de miroir (16) ayant généralement une deuxième valeur de réflectance, et une région active (22) située entre les première et deuxième régions de miroir (16, 26), le procédé comprenant une altération latérale de l'injection de courant et/ou de la réflectance du VCSEL au niveau d'une pluralité de positions discrètes non uniformément dimensionnées et non uniformément positionnées de manière à produire une sortie lumineuse de type à filaments.

2. Procédé selon la revendication 1, dans lequel au moins une des première et deuxième régions de miroir (16, 26) a une pluralité de positions discrètes (52, 58, 66, 72), dans lequel chacune de la pluralité de positions discrètes (52, 58, 66, 72) a une valeur de réflectance différente de la première et deuxième valeur de réflectance correspondante.

3. Procédé selon la revendication 1 ou 2, dans lequel les première et deuxième régions de miroir (16, 26) comprennent chacune une pluralité de couches, dans lequel chacune de la pluralité de positions discrètes (58, 66, 72) correspondant à un objet positionné à l'intérieur d'une ou plusieurs de la pluralité de couches.

4. Procédé selon la revendication 3, dans lequel les première et deuxième régions de miroir (16, 26) sont formées à partir d'un ou plusieurs matériaux, les objets (52, 58, 66, 72) étant formés à partir d'un matériau qui est différent du un ou plusieurs matériaux.

5. Procédé selon la revendication 3, dans lequel l'objet (52, 58, 66, 72) comprend un ou plusieurs atomes dopants.

6. Procédé selon la revendication 4, dans lequel les première et deuxième régions de miroir (16, 26) comprennent chacune une pluralité de couches, dans lequel celles sélectionnées de la pluralité de couches sont saturées avec un dopant prédéterminé, en formant ainsi la pluralité de positions discrètes (52, 58, 66, 72).

7. Procédé selon la revendication 1, dans lequel les première et deuxième régions de miroir (16, 26) comprennent chacune une pluralité de couches, dans lequel au moins une de la pluralité de couches comprend une couche à motif (52) dans lequel le motif correspond à la pluralité de positions discrètes (52, 58, 66, 72).

8. Procédé selon la revendication 7, dans lequel la couche à motif (52) comprend une couche métallique à motif.

9. Procédé selon la revendication 7, dans lequel la couche à motif (52) comprend une couche diélectrique à motif.

10. Procédé selon la revendication 1, dans lequel les première et deuxième régions de miroir (16, 26) comprennent chacune une pluralité de couches, dans lequel chacune de la pluralité de positions discrètes (52, 58, 66, 72) correspond à un trou d'interconnexion positionné à l'intérieur d'une ou plusieurs de la pluralité de couches.

11. Procédé selon la revendication 1, dans lequel une première partie de la pluralité de positions discrètes (52, 58, 66, 72) est d'une première dimension et une deuxième partie de la pluralité de positions discrètes (52, 58, 66, 72) est d'une deuxième dimension.

12. Procédé selon la revendication 1, dans lequel au moins une des première et deuxième régions de miroir (16, 26) a une pluralité de positions discrètes (52, 58, 66, 72), dans lequel chacune de la pluralité de positions discrètes (52, 58, 66, 72) a une valeur de résistance différente de la première et deuxième valeur de résistance correspondante.

13. Procédé selon la revendication 12, dans lequel les première et deuxième régions de miroir (16, 26) comprennent chacune une pluralité de couches, dans lequel chacune de la pluralité de positions discrètes (52, 58, 66, 72) correspond à un objet positionné à l'intérieur d'une ou plusieurs de la pluralité de couches.

14. Procédé selon la revendication 13, dans lequel les première et deuxième régions de miroir (16, 26) sont formées à partir d'un ou plusieurs matériaux, les objets (52, 58, 66, 72) étant formés à partir d'un matériau qui est différent du un ou plusieurs matériaux.

15. Procédé selon la revendication 13, dans lequel l'objet (52, 58, 66, 72) comprend un ou plusieurs atomes dopants.

16. Procédé selon la revendication 13, dans lequel les première et deuxième régions de miroir (16, 26) comprennent chacune une pluralité de couches, dans lequel celles sélectionnées de la pluralité de couches sont saturées avec un dopant prédéterminé, en formant ainsi la pluralité de positions discrètes (52, 58, 66, 72).

17. Procédé selon la revendication 12, dans lequel les première et deuxième régions de miroir (16, 26) comprennent chacune une pluralité de couches, dans lequel au moins une de la pluralité de couches comprend une couche à motif (52) dans lequel le motif correspond à la pluralité de positions discrètes (52, 58, 66, 72).

18. Procédé selon la revendication 17, dans lequel la couche à motif (52) comprend une couche métallique à motif.

19. Procédé selon la revendication 17, dans lequel la couche à motif (52) comprend une couche diélectrique à motif.

20. Procédé selon la revendication 12, dans lequel les première et deuxième régions de miroir (16, 26) comprennent chacune une pluralité de couches, dans lequel chacune de la pluralité de positions discrètes (52, 58, 66, 72) correspondant à un trou d'interconnexion positionné à l'intérieur d'une ou plusieurs de la pluralité de couches.

21. Procédé selon la revendication 12, dans lequel une première partie de la pluralité de positions discrètes (52, 58, 66, 72) est d'une première dimension et une deuxième partie de la pluralité de positions discrètes (52, 58, 66, 72) est d'une deuxième dimension.

22. Procédé selon la revendication 1, comprenant :
la fourniture d'une fenêtre de sortie positionnée au-dessus de la première région de miroir (26) ; et
la fourniture d'une couche à motif (52) située au-dessus de la première région de miroir (26) et sensiblement alignée avec la fenêtre de sortie, dans lequel la couche à motif (52) comprend une pluralité de positions discrètes (52, 58, 66, 72) d'un matériau prédéterminé.

23. Procédé selon la revendication 22, dans lequel la couche à motif (52) comprend une pluralité de trous d'interconnexion.

24. Procédé selon la revendication 1, comprenant :
la fourniture d'une région active (22) située entre les première et deuxième régions de miroir (16, 26), la région active (22) ayant généralement un premier gain, mais ayant en outre une pluralité de positions discrètes dans lequel le gain au niveau de chacune des positions discrètes est différent de la première valeur de gain, en fournissant ainsi la sortie lumineuse de type à filaments.

25. Laser à cavité verticale et à émission par la surface VCSEL pour fournir une sortie lumineuse de type à filaments, comprenant :
une première région de miroir (26) couplée électriquement à une première borne, la première région de miroir (26) ayant généralement une première valeur de réflectance ;
une deuxième région de miroir (16) située sensiblement parallèlement au premier miroir (26) et couplée électriquement à une deuxième borne, la seconde région de miroir (16) ayant généralement une seconde valeur de réflectance ;
au moins une des première et deuxième régions de miroir (16, 26) ayant une pluralité de positions discrètes non uniformément dimensionnées et non uniformément positionnées (52, 58, 66, 72), dans lequel chacune de la pluralité de positions discrètes (52, 58, 66, 72) a une valeur de réflectance différente de la première et deuxième valeur de réflectance correspondante de manière à produire une sortie lumineuse de type à filaments ; et
une région active (22) située entre les première et deuxième régions de miroir (16, 26).

26. VCSEL selon la revendication 25, dans lequel les première et deuxième régions de miroir (16, 26) comprennent chacune une pluralité de couches, dans lequel chacune de la pluralité de positions discrètes (58, 66, 72) correspondant à un objet positionné à l'intérieur d'une ou plusieurs de la pluralité de couches, un objet étant un ou plusieurs de ce qui suit :
- un matériau différent de ceux des première et deuxième régions de miroir ;
- un ou plusieurs atomes dopants ou groupes ou agglomérats de ceux-ci ;
- une couche à motif (par exemple métallique ou diélectrique) ;
- des trous d'interconnexion ;
- une résistance et/ou un gain différent de ceux des première et deuxième régions de miroir.

27. VCSEL selon la revendication 25 ou 26 pouvant être obtenu par le procédé selon l'une quelconque des revendications 1 à 24.
